**Europäisches Patentamt**

**European Patent Office**

**Office européen des brevets**

(11) Veröffentlichungsnummer: **0 370 133**
**A1**

## EUROPÄISCHE PATENTANMELDUNG

(21) Anmeldenummer: 88119624.0

(22) Anmeldetag: 24.11.88

(51) Int. Cl.5: **H05K 3/10, H05K 3/34**

(43) Veröffentlichungstag der Anmeldung:
**30.05.90 Patentblatt 90/22**

(84) Benannte Vertragsstaaten:
**AT BE CH DE ES FR GB GR IT LI LU NL SE**

(71) Anmelder: **Siemens Aktiengesellschaft**
**Wittelsbacherplatz 2**
**D-8000 München 2(DE)**

(72) Erfinder: **Mattelin, Antoon, Dipl.-Ing.**
**Lesliestraat 6**
**B-8020 Oostkamp(BE)**

(54) **Verfahren zur Herstellung von Leiterplatten.**

(57) Auf ein elektrisch isolierendes Substrat (1) werden nacheinander eine erste Metallschicht (2) und ein Plating Resist aufgebracht. Nach dem Belichten und Entwickeln des elektrophoretisch aufgebrachten Plating Resists verbleiben nur dessen belichteten Bereiche (30), so daß auf die übrigen dem Leiterbild entsprechenden Bereiche eine zweite Metallschicht (4) galvanisch aufgebracht werden kann. Anschließend wird ein Solder Resist (5) ebenfalls elektrophoretisch aufgebracht. Nach dem Belichten und Entwickeln des Solder Resist (5) verbleiben nur die belichteten Bereiche (50) auf den späteren Leiterbahnen. Zur Fertigstellung der Leiterplatte braucht dann nur noch das belichtete Plating Resist (30) gestrippt und die dadurch freigelegte erste Metallschicht (2) abgeätzt zu werden.

FIG 6

EP 0 370 133 A1

## Verfahren zur Herstellung von Leiterplatten

Die Erfindung betrifft ein Verfahren zur Herstellung von Leiterplatten der im Anspruch 1 geschilderten Art.

Beim Aufbau von gedruckten Schaltungen bzw. Leiterplatten unterscheidet man grundsätzlich die weitverbreitete Subtraktivtechnik, die von metallkaschierten Substraten bzw. Basismaterialien ausgeht und das nicht für Leiterzüge benötigte Kupfer durch Ätzung entfernt, von der Additivtechnik, die, auf haftvermittlerbeschichteten Substraten aufbauend, das Leiterbahnmaterial nur dort aus Bädern aufbringt, wo Leiterzüge benötigt werden. Auch Kombinationen dieser Verfahren sind üblich. So ist es beispielsweise bekannt, bei der Herstellung von Leiterplatten die beidseitig mit einer Kupferkaschierung angelieferten isolierenden Substrate nach dem Bohren der Durchgangsbohrungen mit einer schwachen Kupferschicht zu überziehen, die die Kupferkaschierung und die Oberfläche der Durchgangsbohrungen bedeckt. Auf die so gebildete Kupferschicht wird eine Fotoresistschicht aufgewalzt. Hierauf wird auf die Fotoresistschicht eine Maske mit dem gewünschten Leiterbild aufgelegt und nach einem Belichtungsschritt wieder entfernt. Beim anschließenden Entwickeln werden die für eine weitere Kupferbeschichtung freizuhaltenden Oberflächenbereiche des Substrats von der Fotoresistschicht wieder befreit. Es verbleiben die gewünschten Leiterbahnen und Durchkontaktierungen der Leiterplatte. Die Leiterbahnen werden anschließend galvanisch verstärkt und ebenfalls zusammen mit den Durchkontaktierungen galvanisch mit einer Zinnschicht überzogen.

Bei den herkömmlichen lichtempfindlichen Fotoresistschichten, bei welchen es sich je nach der angewandten Technik um Plating Resists oder Ätzresists handeln kann, erfolgt das Aufbringen des flüssigen Resistmaterials durch Tauchen, Aufwalzen oder Schleuderbeschichten. Es ist aber auch möglich, das Resistma terial in Form eines sogenannten Trockenfilmresists unter Anwendung einer geeigneten Klebevorrichtung aufzulaminieren.

Aus der DE-A-36 28 340 ist auch bereits ein Verfahren zur Herstellung von Leiterplatten mit den gewünschten Leiterzügen unter Anwendung eines auf einer Oberfläche eines kupferplattierten isolierenden Substrats aufgebrachten lichtempfindlichen Resistfilms bekannt, welches darin besteht, daß man den lichtempfindlichen Resistfilm galvanisch durch Eintauchen des isolierenden Substrats in ein wasserlösliche oder in Wasser dispergierbare, unter Lichteinwirkung aushärtende Kunststoffe als Hauptbestandteile enthaltendes Abscheidungsbad unter Anwendung von Gleichstrom auf der Oberfläche des isolierenden Substrats abscheidet. Das strukturierbare Resist wird hier also elektrophoretisch aufgebracht, wobei eine derartige Aufbringung beim Einsatz in der industriellen Serienlackierung häufig auch als anodische oder kathodische Elektrotauchlackierung bezeichnet wird.

Der Erfindung liegt die Aufgabe zugrunde ein einfaches und wirtschaftliches Verfahren zur Herstellung von Leiterplatten zu schaffen, bei welchem die Leiterbahnen mit einem Solder Resist bzw. Lötstopp-Lack beschichtet werden und die übrigen Bereiche des Leiterbildes wie Durchkontaktierungen oder Lötpads auf einfache Weise belotet werden können.

Diese Aufgabe wird erfindungsgemäß durch die im Anspruch 1 aufgeführten Merkmale gelöst.

Bei dem erfindungsgemäßen Verfahren werden also sowohl das Plating Resist als auch das Solder Resist elektrophoretisch aufgebracht, wodurch sich insgesamt gesehen ein äußerst wirtschaftliches und problemlos durchzuführendes Fertigungskonzept ergibt.

Bevorzugte Ausgestaltungen des erfindungsgemäßen Verfahrens gehen aus den Unteransprüchen hervor.

Ein Ausführungsbeispiel der Erfindung ist in der Zeichnung dargestellt und wird im folgenden näher beschrieben.

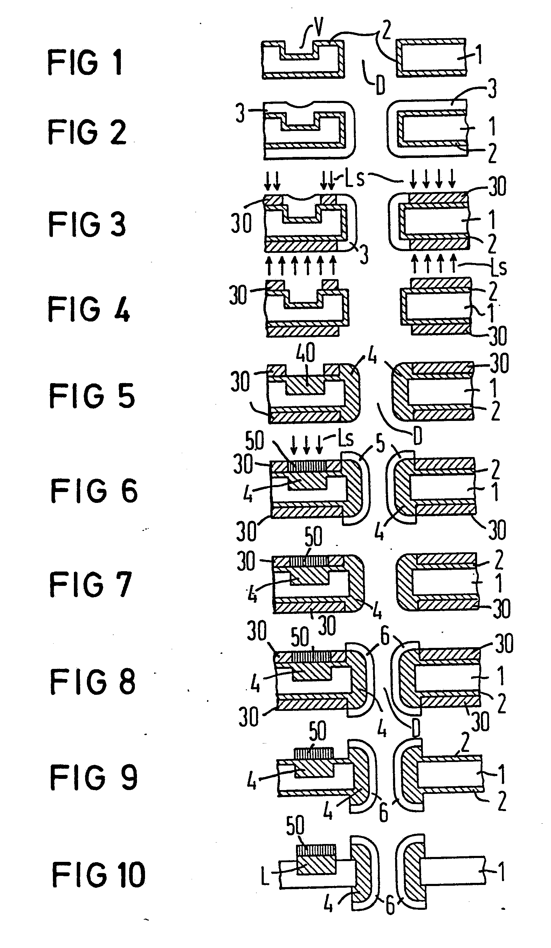

Die Fig. 1 bis 10 zeigen in stark vereinfachter schematischer Darstellung die wesentlichen Verfahrensstadien bei der Herstellung einer Leiterplatte.

Fig. 1 zeigt einen Schnitt durch einen Teil eines beispielsweise aus glasfaserverstärktem Polyetherimid bestehenden isolierenden Substrats 1. In dieses Substrat 1 werden bereits bei der Herstellung durch Spritzgießen im Bereich der späteren Leiterbahnen verlaufende Vertiefungen V und Durchkontaktierungslöcher D eingebracht. Es ist zu erkennen, daß die gesamte Oberfläche des Substrats 1 unter Einschluß der Vertiefungen V und der Durchkontaktierungslöcher D mit einer dünnen ersten Metallschicht 2 überzogen ist. Diese Metallschicht 2 besteht beispielsweise aus einer durch stromlose Metallabscheidung aufgebrachten Kupferschicht die anschließend durch galvanische Kupferabscheidung verstärkt wurde. Die Stärke dieser ersten Metallschicht 2 beträgt beispielsweise 2,5 µm.

Gemäß Fig. 2 wird auf die erste Metallschicht 2 eine Schicht eines strukturierbaren Plating Resists 3 aufgebracht. Das Aufbringen dieses lichtempfindlichen Plating Resists 3 erfolgt elektrophoretisch, d.h. durch Elektrotauchlackierung. Bei dem elektrophoretisch aufgebrachten Plating Resist 3 handelt es sich beispielsweise um das von der Fa. Shipley unter dem Handelsnamen "Eagle TM" vertriebene

Resistmaterial.

Nach dem elektrophoretischen Aufbringen des Plating Resists 3 auf die erste Metallschicht 2 erfolgt die in Fig. 3 dargestellte Strukturierung des Plating Resists 3. Es ist zu erkennen, daß die nicht dem gewünschten Leiterbild entsprechenden Bereiche des Plating Resists 3 mit Hilfe von Lichtstrahlen Ls belichtet werden. Die derart belichteten Bereiche des Plating Resists 3 sind durch die Bezugsziffer 30 gekennzeichnet. Das Belichten des Plating Resists 3 zum Zwecke der Strukturierung kann entweder mit Hilfe einer entsprechenden Maske oder aber beispielsweise mit Hilfe eines Lasers vorgenommen werden. Beim Einsatz eines Lasers wie z.B. eines Excimer-Lasers wird der Laserstrahl entsprechend abgelenkt, so daß hier auf eine Maske verzichtet werden kann.

Gemäß Fig. 4 werden bei dem anschließenden Entwickeln die unbelichteten Bereiche des Plating Resists 3 entfernt, d.h. auf dem Substrat 1 verbleiben lediglich die nicht dem gewünschten Leiterbild entsprechenden und mit den Lichtstrahlen Ls belichteten Bereiche 30.

Gemäß Fig. 5 werden anschließend die beim Entwickeln von dem Plating Resist 3 befreiten Bereiche der ersten Metallschicht 2 durch eine galvanisch aufgebrachte zweite Metallschicht 4 verstärkt. Das Aufbringen dieser zweiten Metallschicht 4 erfolgt durch die galvanische Abscheidung von Kupfer in einer Stärke zwischen 30 und 35 μm. Es ist zu erkennen, daß die zweite Metallschicht 4 im Bereich der späteren Leiterbahnen und im Bereich der Durchkontaktierungen D aufgebracht wurde.

Anschließend wird die galvanisch aufgebrachte zweite Metallschicht 4 elektrophoretisch mit einem strukturierbaren Solder Resist 5 beschichtet. Fig. 6 zeigt, daß das derart aufgebrachte Solder Resist 5 im Bereich der späteren Leiterbahnen mit Lichtstrahlen Ls belichtet wird. Die belichteten Bereiche des Solder Resists 5 sind mit der Bezugsziffer 50 gekennzeichnet. Die Belichtung des Solder Resists 5 kann auch hier wieder mit Hilfe einer entsprechenden Maske oder mit Hilfe eines ablenkbaren Laserstrahls vorgenommen werden.

Beim anschließenden Entwickeln des Solder Resists 5 werden gemäß Fig. 7 die unbelichteten Bereiche entfernt, d.h. es verbleiben lediglich die belichteten Bereiche 50 im Bereich der späteren Leiterbahnen.

Gemäß Fig. 8 wird anschließend im Bereich der Durchkontaktierungen D oder aber auch im Bereich von in der Zeichnung nicht dargestellten Lötpads eine dritte Metallschicht 6 galvanisch abgeschieden. Bei dieser dritten Metallschicht 6 handelt es sich beispielsweise um eine Zinn/Blei-Legierung.

Gemäß Fig. 8 erfolgt anschließend das Strippen des Plating Resists 3, d.h. die galvanisch nicht verstärkten Bereiche der ersten Metallschicht 2 werden freigelegt. Gemäß Fig. 10 können die derart freigelegten Bereiche der ersten Metallschicht 2 dann bis zur Oberfläche des Substrats 1 abgeätzt werden. Es verbleibt die fertige Leiterplatte mit den durch das Solder Resist 50 abgedeckten Leiterbahnen L und den mit der dritten Metallschicht 6 überzogenen Durchkontaktierungen D. Beim Einlöten von Bauelementen werden somit die Leiterbahnen L nicht mit Lot überzogen. Die Benetzung des Lotes beschränkt sich beim Einlöten der Bauelemente auf den Bereich der Durchkontaktierungen D oder aber auch auf den Bereich von in der Zeichnung nicht dargestellten Lötpads.

Bei dem Solder Resist 5 handelt es sich wie bei dem Plating Resist 3 um ein elektrophoretisch aufbringbares Resistmaterial, wobei in beiden Fällen grundsätzlich eine anodische oder kathodische Elektrotauchlackierung möglich ist. Entscheidend ist dabei lediglich, daß beim Strippen des Plating Resists 3 das belichtete Solder Resist 50 nicht gestrippt wird. Somit muß es sich bei dem Plating Resist 3 und dem Solder Resist 5 grundsätzlich um verschiedene Resistmaterialien handeln, die ein selektives Strippen ermöglichen. Weitere Resistmaterialien gehen beispielsweise aus der eingangs genannten DE-A-36 28 340 hervor.

## Ansprüche

1. Verfahren zur Herstellung von Leiterplatten mit folgenden Verfahrensschritten:

a) auf mindestens eine Seite eines elektrisch isolierenden Substrats (1) wird eine erste Metallschicht (2) aufgebracht;

b) die im Schritt a) aufgebrachte Metallschicht (2) wird elektrophoretisch mit einem strukturierbaren Plating Resist (3) beschichtet;

c) das im Schritt b) aufgebrachte Plating Resist (3) wird in den dem späteren Leiterbild entsprechenden Bereichen wieder entfernt;

d) auf die im Schritt c) freigelegten Bereiche der ersten Metallschicht (2) wird durch galvanische Metallabscheidung eine zweite Metallschicht (4) aufgebracht;

e) die im Schritt d) aufgebrachte zweite Metallschicht (4) wird elektrophoretisch mit einem strukturierbaren Solder Resist (5) beschichtet;

f) das im Schritt e) aufgebrachte Solder Resist (5) wird in den nicht den Leiterbahnen (L) entsprechenden Bereichen des späteren Leiterbildes wieder entfernt;

g) das im Schritt b) aufgebrachte Plating Resist (3) wird durch Strippen vollständig entfernt;

h) die im Schritt g) freigelegten Bereiche der ersten Metallschicht (2) werden bis zur Oberfläche des Substrats (1) weggeätzt.

2. Verfahren nach Anspruch 1,
**dadurch gekennzeichnet,**
daß ein mit Durchkontaktierungslöchern (D) versehenes Substrat (1) verwendet wird.

3. Verfahren nach Anspruch 1 oder 2,
**dadurch gekennzeichnet,**
daß ein im Bereich der späteren Leiterbahnen (L) mit Vertiefungen (V) versehenes Substrat (1) verwendet wird.

4. Verfahren nach einem der vorhergehenden Ansprüche,
**dadurch gekennzeichnet,**
daß ein dreidimensionales, spritzgegossenes Substrat verwendet wird.

5. Verfahren nach einem der vorhergehenden Ansprüche,
**dadurch gekennzeichnet,**
daß die Strukturierung des Plating Resists (3) gemäß Schritt c) durch Belichten der nicht dem späteren Leiterbild entsprechenden Bereiche und anschließendes Entwickeln vorgenommen wird.

6. Verfahren nach einem der vorhergehenden Ansprüche,
**dadurch gekennzeichnet,**
daß die Strukturierung des Solder Resists (5) gemäß Schritt f) durch Belichten der den Leiterbahnen (L) entsprechenden Bereiche des späteren Leiterbildes und anschließendes Entwickeln vorgenommen wird.

7. Verfahren nach einem der vorhergehenden Ansprüche,
**dadurch gekennzeichnet,**
daß auf die im Schritt f) freigelegten Bereiche der zweiten Metallschicht (4) eine dritte Metallschicht (6) aufgebracht wird.

8. Verfahren nach Anspruch 7,
**dadurch gekennzeichnet,**
daß die dritte Metallschicht (6) durch galvanische Metallabscheidung aufgebracht wird.

9. Verfahren nach Anspruch 7 oder 8,
**dadurch gekennzeichnet,**
daß als dritte Metallschicht (6) Zinn oder eine Zinn/Blei-Legierung aufgebracht wird.

FIG 1

FIG 2

FIG 3

FIG 4

FIG 5

FIG 6

FIG 7

FIG 8

FIG 9

FIG 10

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | WO-A-7 900 083  (R. MACK) * Seite 12, Zeile 35 - Seite 13, Zeile 20 * | 1,2,5-9 | H 05 K  3/10 H 05 K  3/34 |
| A | DE-A-1 665 151  (MONTAN FORSCHUNG) * Spalte 2, Zeile 50 - Spalte 3, Zeile 12 * | 1,2,5,6 | |
| A | EP-A-0 133 917  (INTERNATIONAL BUSINESS MACHINES CO.) * Figuren * | 3,4 | |
| D,A | DE-A-3 628 340  (MITSUBISHI DENKI) | | |
| A | US-A-4 608 274  (J. WOOTEN) | | |

**RECHERCHIERTE SACHGEBIETE (Int. Cl.5)**

H 05 K

Der vorliegende Recherchenbericht wurde für alle Patentansprüche erstellt

| Recherchenort | Abschlußdatum der Recherche | Prüfer |
|---|---|---|
| DEN HAAG | 21-07-1989 | MOMENE Y ARROYO M.E. |